# DEMANDE DE BREVET EUROPEEN

(11) **EP 1 517 598 A1**
(43) Date de publication de la demande: **23.03.2005**
(21) Numéro de dépôt: 03020998.5
(22) Date de dépôt: 17.09.2003
(51) Int. Cl.: H05K 3/30, G01L 9/00, H01L 23/29

(54) **Procédé de montage d'un composant électronique sur un support**

(71) Demandeur: ASULAB S.A., 2074 Marin (CH)
(72) Inventeur: Born, Jean-Jacques, CH-1110 Morges (CH)
(74) Mandataire: Thérond, Gérard Raymond

(57) **Abrégé**

La présente invention concerne un procédé de montage d'un composant électronique sur un support, ce procédé comprenant les étapes consistant à :
- coller temporairement le composant sur son support de manière rigide;
- réaliser au moins une étape de procédé supplémentaire, et
- désolidariser le composant du support,
le procédé étant caractérisé en ce que le composant est collé sur le support au moyen d'une colle thermofusible (4) et en ce qu'après achèvement de la ou des étapes de procédé supplémentaires, on fait fondre la colle thermofusible (4) par élévation localisée de la température tout en exerçant une traction sur le composant afin de le dégager de la colle fondue.

## Description

La présente invention concerne un procédé de montage d'un composant électronique tel qu'un capteur de pression atmosphérique sur un support, par exemple une plaquette de circuit imprimé.

On connaît par la demande internationale WO 00/39644 au nom de la demanderesse une montre comprenant un capteur de pression atmosphérique. Ce capteur de pression est un capteur piézo-résistif de type connu et peu coûteux, fait d'un élément en silicium micro-usiné comportant une membrane dont une face est exposée à la pression ambiante, tandis que l'autre face porte des résistances connectées en pont de Wheatstone. Les résistances sont disposées de telle façon que les variations de pression créent un déséquilibre du pont se traduisant par des variations de la tension aux bornes de sortie du pont. Ainsi, par des fils de connexion le reliant directement à une plaquette de circuit imprimé, le capteur fournit à un circuit intégré des signaux de sortie représentatifs de la pression à laquelle ce capteur est exposé.

Jusqu'à présent, les capteurs de pression étaient montés sur les plaquettes de circuit imprimé au moyen d'une colle souple à base de silicone afin que le couplage mécanique entre capteurs et circuits imprimés soit aussi lâche que possible. En effet, les capteurs de pression atmosphérique sont très sensibles aux contraintes mécaniques qui peuvent fausser la mesure de la pression. Ces contraintes mécaniques peuvent être engendrées par des variations de dimensions des circuits imprimés sous l'effet des fluctuations de la température ambiante ou bien encore lors de l'emboîtage des capteurs dans les boîtes de montres. On s'est malheureusement rendu compte qu'en raison de la faible rigidité de la liaison entre les capteurs et les circuits imprimés, lesdits capteurs s'animaient d'un mouvement de va-et-vient lors du soudage des fils de connexion par frottage ultrasonique, opération mieux connue sous sa dénomination anglo-saxonne "wire bonding", ce qui nuisait au bon soudage de ces fils.

Une première solution à ces problèmes a été décrite dans la demande de brevet allemand DE 101 12 534 publiée le 19 septembre 2002 au nom de la société Keller AG für Druckmesstechnik. Cette solution consiste à coller provisoirement un dispositif électronique tel qu'un capteur de pression atmosphérique sur un support, par exemple un circuit imprimé, au moyen d'un adhésif tel qu'une colle à papier ou une colle alimentaire, puis à réaliser au moins une étape supplémentaire de procédé, notamment le soudage des fils de connexion entre le capteur de pression et le circuit imprimé, et enfin à éliminer l'adhésif au moyen d'eau ou d'un solvant de sorte que le dispositif électronique se retrouve dissocié du support.

Grâce à cette solution, le capteur de pression atmosphérique se trouve lié temporairement de façon rigide au circuit imprimé sur lequel il est monté. Ceci permet de réaliser toute opération de fabrication ultérieure et, notamment, le soudage des fils de connexion par wire bonding, dans de bonnes conditions. Par contre, l'étape finale de lavage à l'eau ou à l'aide d'un solvant destinée à éliminer l'adhésif risque de provoquer une pollution du circuit imprimé et d'entraîner des dysfonctionnements de ce dernier, ce qui ne peut être accepté.

La présente invention a pour but de remédier aux inconvénients susmentionnés ainsi qu'à d'autres encore en procurant un procédé de montage d'un composant électronique sur un support qui permet de coller temporairement le composant électronique sur son support de façon rigide, de réaliser au moins une étape de procédé supplémentaire, et de désolidariser le composant de son support sans risquer d'endommager ledit support.

A cet effet, la présente invention concerne un procédé de montage d'un composant électronique tel qu'un capteur de pression atmosphérique sur un support, par exemple une plaquette de circuit imprimé, ce procédé comprenant les étapes consistant à :
- coller temporairement le composant sur son support de manière rigide;
- réaliser au moins une étape de procédé supplémentaire, et
- désolidariser le composant du support,
le procédé étant caractérisé en ce que le composant est collé sur le support au moyen d'une colle thermofusible et en ce qu'après achèvement de la ou des étapes de procédé supplémentaires, on fait fondre la colle thermofusible par élévation localisée de la température tout en exerçant une traction sur le composant afin de le dégager de la colle fondue.

Grâce à ces caractéristiques, la présente invention procure un procédé dans lequel tout risque de polluer le support sur lequel est monté le composant électronique est évité. En effet, lorsque l'on fait fondre la colle thermofusible par élévation de la température, celle-ci forme sur le support une gouttelette qui ne va pas migrer. Il suffit ensuite d'exercer une légère traction sur le composant afin de le dégager de la colle fondue, puis de ramener ladite colle à température ambiante afin qu'elle se solidifie à nouveau. Bien entendu, la température à laquelle doit être portée la colle thermofusible pour fondre est telle qu'elle ne risque pas de détériorer le composant.

Selon une autre caractéristique du procédé, l'étape supplémentaire consiste à souder des fils de connexion par wire bonding entre le composant et son support.

Selon encore une autre caractéristique de l'invention, la colle thermofusible est un produit qui est connu sous le nom de gomme laque dans le domaine de la fabrication horlogère.

D'autres caractéristiques et avantages de la présente invention ressortiront plus clairement de la description détaillée qui suit d'un exemple de mise en oeuvre du procédé selon l'invention, cet exemple étant donné à titre purement illustratif et non limitatif seulement en liaison avec le dessin annexé sur lequel :

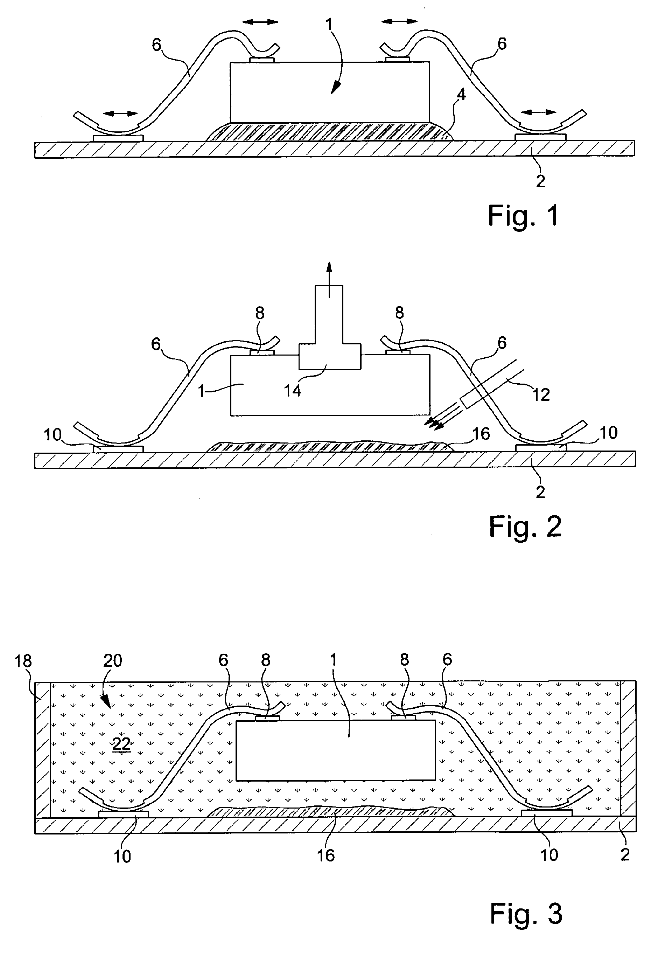

- la figure 1 est une représentation schématique d'un capteur de pression atmosphérique fixé temporairement de façon rigide sur une plaquette de circuit imprimé pendant que l'on procède au soudage par frottage ultrasonique des fils de connexion destinés à relier les bornes de sotie du capteur à des pistes conductrices du circuit imprimé;
- la figure 2 est une vue analogue à celle de la figure 1 représentant l'étape de désolidarisation du capteur de pression de sa plaquette de circuit imprimé, étape durant laquelle on dirige un jet d'air chaud sur la colle thermofusible tout en exerçant une légère traction sur le capteur afin de le dégager de la colle fondue, et
- la figure 3 est une vue analogue à celle de la figure 1 représentant le capteur de pression suspendu par ses fils de connexion au-dessus de la plaquette de circuit imprimé et noyé dans un gel silicone.

La présente invention procède de l'idée générale inventive qui consiste à coller temporairement de façon rigide un composant électronique sur un support au moyen d'une colle thermofusible. Aussi longtemps que le composant est fixé rigidement sur son support, on peut procéder à des étapes ultérieures du procédé et, en particulier, au soudage par frottage ultrasonique des fils de connexion destinés à relier les bornes de sortie du composant à des pistes conductrices ménagées sur le support. Après achèvement des opérations de procédé, on dirige un jet d'air chaud en direction de la colle thermofusible, ce qui la fait fondre. Dans le même temps, on exerce une légère traction sur le composant afin de le dégager de la colle. Après retour à la température ambiante, la colle thermofusible durcit, de sorte que le composant se retrouve suspendu au-dessus du support par ses fils de connexion, libre de toute contrainte mécanique. Ainsi, grâce au procédé selon l'invention, il n'est pas nécessaire de laver le support, opération qui risque de polluer, voire de détériorer ledit support. Au contraire, la colle thermofusible forme, après avoir fondu, une petite goutte résiduelle qui ne migre pas à la surface du support.

La présente invention va être décrite en liaison avec un capteur de pression atmosphérique monté à la surface d'une plaquette de circuit imprimé. Il va de soi que cet exemple est donné à titre purement illustratif et non limitatif seulement, la présente invention pouvant s'appliquer au montage de tout type de composant électronique, en particulier ceux sensibles aux contraintes mécaniques, sur un support donné.

La figure 1 est une représentation schématique d'un capteur de pression atmosphérique 1 fixé temporairement de manière rigide sur une plaquette de circuit imprimé 2 au moyen d'une couche de colle thermofusible 4. La colle thermofusible 4 correspond préférentiellement mais non limitativement au produit connu sous le nom de "gomme laque" dans le domaine de l'horlogerie. Il s'agit d'un produit qui, au contact de l'air, durcit par évaporation d'un solvant qu'il renferme et permet de solidariser deux éléments. Dans le cas présent, la couche de colle thermofusible 4 permet de fixer temporairement et de manière rigide le capteur de pression 1 sur la plaquette de circuit imprimé 2.

On profite du fait que le capteur de pression 1 est fixé rigidement sur le circuit imprimé 2 pour réaliser au moins une étape de procédé supplémentaire. Conformément à l'invention, cette étape consiste à souder des fils de connexion 6 pour relier entre elles les bornes de sortie 8 du capteur de pression 1 et des pistes conductrices 10 ménagées à la surface du circuit imprimé 2.

Les fils de connexion 6 peuvent être en aluminium ou en or. Quant aux pistes conductrices 10, elles comprennent typiquement trois couches successives de cuivre, de nickel et d'or, la couche d'or au niveau de laquelle s'opère la jonction avec les fils de connexion 6 ayant habituellement une épaisseur de l'ordre de 0,2 microns. Les fils de connexion 6 sont soudés sur les bornes de sortie 8 du capteur 1 et les pistes conductrices 10 du circuit imprimé 2 par frottage ultrasonique dans le sens des doubles flèches représentées à la figure 1. La fréquence de frottage est de l'ordre de 20 à 25 kHz, de façon à provoquer localement une fusion des fils de connexion 6 qui permettra leur bonne adhésion sur les bornes de sortie 8 et les pistes conductrices 10. Lié rigidement à la plaquette de circuit imprimé 2, le capteur de pression atmosphérique 1 ne gêne pas l'opération de soudage des fils de connexion 6 en s'animant d'un mouvement de va-et-vient comme tel était le cas dans l'art antérieur.

Après réalisation de toutes les étapes de procédé supplémentaires et, en particulier, le soudage des fils de connexion 6, on procède à la désolidarisation du capteur de pression 1. Pour cela, on dirige, par exemple au moyen d'une buse 12 , un flux d'air chaud en direction de la couche de colle thermofusible 4 (voir figure 2). Sous l'effet de l'élévation de la température, la colle thermofusible 4 se met à fondre. Bien entendu, la température à laquelle la colle thermofusible 4 fond a une valeur telle qu'elle ne risque pas d'endommager le capteur de pression 1. En même temps que la colle themofusible 4 fond, on exerce une légère traction verticale, par exemple au moyen d'une pince 14, sur le capteur de pression 1 afin de le dégager de la colle. Afin que cette opération soit rendue possible, il faut que les fils de connexion 6 aient une longueur suffisante pour ne pas casser. On ramène ensuite la colle thermofusible 4 à la température ambiante, sous l'effet de quoi elle se solidifie à nouveau pour ne plus former qu'une gouttelette résiduelle 16 à la surface du circuit imprimé 2. Lorsque la colle 4 fond, elle ne migre pas à la surface du circuit imprimé 2, de sorte qu'elle ne risque pas de polluer ce dernier. De même, les opérations de lavage du circuit imprimé 2 qui, elles aussi, risqueraient de polluer, voire de détériorer le circuit imprimé 2, sont évitées.

Après désolidarisation, le capteur de pression 1 se retrouve suspendu par ses fils de connexion 6 au-dessus de la plaquette de circuit imprimé 2 (voir figure 3). Il ne reste plus qu'à entourer le capteur 1 d'une cloison 18 qui délimite un volume 20 que l'on vient remplir au moyen d'un gel silicone 22. Ce gel 22 a pour avantage de protéger le capteur de pression 1 contre l'eau, l'humidité et les poussières tout en transmettant intégralement la pression atmosphérique.

Il va de soi que la présente invention n'est pas limitée au mode de mise en oeuvre qui vient d'être décrit, et que diverses modifications et variantes simples peuvent être envisagées par l'homme du métier sans sortir du cadre de la présente invention.

## Revendications

1. Procédé de montage d'un composant électronique sur un support, ce procédé comprenant les étapes consistant à:
- coller temporairement le composant sur son support de manière rigide;
- réaliser au moins une étape de procédé supplémentaire, et
- désolidariser le composant du support,
le procédé étant **caractérisé en ce que** le composant est collé sur le support au moyen d'une colle thermofusible (4) et **en ce qu'**après achèvement de la ou des étapes de procédé supplémentaires, on fait fondre la colle thermofusible (4) par élévation localisée de la température tout en exerçant une traction sur le composant afin de le dégager de la colle fondue.

2. Procédé selon la revendication 1, **caractérisé en ce que** l'étape supplémentaire consiste à souder des fils de connexion (6) par wire bonding entre le composant et son support.

3. Procédé selon l'une quelconque des revendications 1 ou 2, **caractérisé en ce que** la colle thermofusible est de la gomme laque.

4. Procédé selon l'une quelconque des revendications 1 à 3, **caractérisé en ce que** le composant est un capteur de pression atmosphérique (1) et **en ce que** le support est une plaquette de circuit imprimé (2).
